# FASCICULE DE BREVET EUROPEEN

(11) **EP 3 612 504 B1**
(45) Date de publication et mention de la délivrance du brevet: **11.10.2023**
(21) Numéro de dépôt: 18719800.7
(22) Date de dépôt: 16.04.2018
(51) Int. Cl.: C04B 35/628, C04B 35/111, C04B 35/117, C04B 35/119, C04B 35/44, C04B 35/486, C04B 35/488, C04B 35/626, C04B 35/632, C04B 35/634, C04B 35/638, G04B 45/00, G04B 37/22, C23C 14/22, C23C 16/44, C23C 16/455, C22C 29/12, G04B 19/12, C22C 1/10, C04B 111/82, A44C 27/00

(54) **FABRICATION D'UN COMPOSANT EN CÉRAMIQUE**
HERSTELLUNG EINES KERAMIK-BAUTEILS
PRODUCTION OF A CERAMIC COMPONENT

(30) Priorité: 20.04.2017 EP 17167229
(43) Date de publication de la demande: 26.02.2020
(73) Titulaire: ROLEX SA, 1211 Genève 26 (CH)
(72) Inventeur: BOCCARD, Cyriaque, 74140 Douvaine (FR); PUJOL, Ollivier, 1006 Lausanne (CH)
(74) Mandataire: Moinas & Savoye SARL
(86) Numéro de dépôt international: PCT/EP2018/059691
(87) Numéro de publication internationale: WO 2018/192885

(56) Documents cités:
- EP-A1- 0 345 795
- EP-A1- 2 746 242
- WO-A1-2016/147208
- GB-A- 2 501 763
- JP-A- H05 270 820
- JP-A- S56 130 469
- US-A1- 2003 026 989
- ITOH H ET AL: "MICROSTRUCTURE AND PROPERTIES OF THE SINTERED COMPOSITE PREPARED BYHOT PRESSING OF TIN-COATED ALUMINA POWDER", JOURNAL OF MATERIALS SCIENCE, KLUWER ACADEMIC PUBLISHERS, DORDRECHT, vol. 28, no. 24, 15 décembre 1993 (1993-12-15), pages 6761-6766, XP000415573, ISSN: 0022-2461, DOI: 10.1007/BF00356428
- ENSINGER W ET AL: "Noble metal deposition on aluminum oxide powder surfaces by ion beam sputtering", NUCLEAR INSTRUMENTS & METHODS IN PHYSICS RESEARCH. SECTION B: BEAM INTERACTIONS WITH MATERIALS AND A, ELSEVIER BV, NL, vol. 141, no. 1-4, mai 1998 (1998-05), pages 693-698, XP004440775, ISSN: 0168-583X, DOI: 10.1016/S0168-583X(98)00173-6
- SEBASTIAN BRUST ET AL: "CVD Coating of Oxide Particles for the Production of Novel Particle-Reinforced Iron-Based Metal Matrix Composites", OPEN JOURNAL OF APPLIED SCIENCES, vol. 06, no. 04, 27 avril 2016 (2016-04-27), pages 260-269, XP055417214, ISSN: 2165-3917, DOI: 10.4236/ojapps.2016.64026
- MCCORMICK J ET AL: "Rotary reactor for atomic layer deposition on large quantities of nanoparticles", JOURNAL OF VACUUM SCIENCE AND TECHNOLOGY: PART A, AVS /AIP, MELVILLE, NY., US, vol. 25, no. 1, 2 janvier 2007 (2007-01-02), pages 67-74, XP012102560, ISSN: 0734-2101, DOI: 10.1116/1.2393299

## Description

### Introduction

La présente invention concerne un procédé de fabrication d'une poudre céramique et d'un composant en céramique. Une telle poudre et un tel composant en céramique trouvent des applications dans l'horlogerie, la joaillerie ou la bijouterie. Particulièrement, un tel composant trouve des applications dans une pièce d'horlogerie, notamment pour les composants de décoration, comme une lunette ou des composants fonctionnels, comme des pièces de mouvement.

### Etat de l'Art

Dans le domaine de l'horlogerie, de même que dans la bijouterie ou la joaillerie, il est connu d'utiliser des composants en céramique, notamment des composants de décoration. Mais une limite dans l'utilisation de ces composants en céramique provient de la difficulté, voire l'impossibilité, à obtenir certaines couleurs, notamment certaines teintes grises, et de la difficulté à obtenir une couleur homogène, prévisible et reproductible. De plus, l'obtention d'une teinte particulière nécessite l'élaboration d'un lot de matière complet à partir des composants initiaux et s'avère chronophage et complexe (voir EP2746242A1).

Une autre limite provient de même de la difficulté à tester l'effet d'ajouts de certains éléments, qui peuvent se combiner aux constituants de céramiques connues, notamment pour obtenir certaines caractéristiques mécaniques particulières du composant en céramique. Ici également, chaque essai est complexe et nécessite la mise en oeuvre d'un lot de matière complet à partir des composants initiaux.

Le procédé habituel de fabrication d'un composant en céramique comprend une première phase consistant à préparer la matière première, c'est-à-dire la poudre céramique, comme par exemple une poudre céramique à base de zircone et/ou d'alumine. Dans cette première phase, cette matière première est en général préparée sous forme de poudre céramique à laquelle on peut ajouter par exemple d'autres oxydes pour renforcer le composant céramique ou des pigments en vue d'obtenir une matière colorée. Les pigments sont en général du type oxyde métallique ou oxyde de terre rare, et sont ajoutés et mélangés à la poudre céramique de base par voie liquide, les pigments étant ainsi introduits par un liquide porteur.

Une deuxième phase du procédé de fabrication d'un composant en céramique consiste à intégrer un liant à la poudre céramique obtenue par la première phase. Un tel liant est en général constitué d'un ou plusieurs composés organiques. La nature et la proportion du liant dépendent du procédé prévu dans une troisième phase, et à l'issue de cette phase on parle de manière générale de poudre céramique liantée.

La troisième phase consiste en une mise en forme du composant en céramique. Pour cela, une première approche comprend une étape de pressage d'un agglomérat de particules liantées obtenues en fin de deuxième phase : dans un tel procédé, la deuxième phase prépare une poudre céramique liantée sous forme de granules atomisés de pressage. Une deuxième approche consiste en une mise en forme par injection dans un moule. Dans un tel cas, la préparation résultant de la deuxième phase est une poudre céramique liantée appelée par sa dénomination anglaise « feedstock ». Une troisième approche consiste en une mise en forme par coulage dans un moule, communément appelée coulage en barbotine. Dans un tel cas, la préparation résultant de la deuxième phase est une poudre céramique liantée en suspension appelée par sa dénomination anglaise « slurry » et barbotine en français. A la fin de la troisième phase, le composant en céramique présente une forme qui se rapproche de sa forme finale et contient à la fois la poudre céramique et le liant. D'autres techniques de mise en forme, comme le gel casting, freeze casting ou encore les techniques de Coagulation Casting peuvent être utilisées.

Une quatrième phase permet de finaliser le composant en céramique. Cette quatrième phase comprend une première étape consistant à délianter le composant, c'est-à-dire à supprimer le liant, par exemple par un traitement thermique ou au moyen d'un solvant. Une deuxième étape permet de densifier le composant en éliminant les pores provenant du déliantage. Cette deuxième étape consiste en général en un traitement thermique de frittage (une cuisson à haute température). La couleur finale du composant en céramique, ainsi que ses propriétés mécaniques finales, apparaissent uniquement à la fin de cette quatrième phase et sont issues des réactions entre les différents constituants du composant mais également de l'atmosphère présente dans le four, qui interviennent lors du traitement thermique. Ces réactions sont complexes et parfois imprévisibles.

On constate que le procédé traditionnel de fabrication d'un composant en céramique, rappelé ci-dessus, présente plusieurs inconvénients. Particulièrement, la couleur et les propriétés finales obtenues dépendent de nombreux paramètres, comme la microstructure de la poudre formée dans la première phase, notamment la taille des grains de céramique, la taille des pigments, leur réactivité avec la céramique et l'environnement de frittage, etc. Elles dépendent de plus de tous les autres facteurs liés aux autres phases de fabrication, comme la taille et le nombre de pores dans le composant final, la composition des joints de grains, la densité, le pourcentage du ou des pigments ainsi que leur répartition dans la matrice, leur éventuelle combinaison entre eux ou avec les constituants de la matière première céramique ou l'atmosphère lors du frittage, la pureté chimique des composés initiaux et l'éventuelle présence de contaminants intrinsèques et extrinsèques. Cette multiplicité de paramètres à prendre en compte rend difficile la prédictibilité et la reproductibilité d'une certaine couleur qu'on souhaite fabriquer. Cette constatation est d'autant plus vraie si la quantité de pigments de coloration est faible : ainsi, pour réduire cet inconvénient, tous les procédés existants utilisent nécessairement une quantité importante de pigments. De plus, certains procédés tentent d'améliorer le résultat en ajoutant des étapes basées sur de la chimie complexe, ce qui présente naturellement l'inconvénient de complexifier davantage le procédé de fabrication.

D'autre part, la difficulté de gestion des couleurs d'un composant en céramique induit en pratique la nécessité de nombreux essais, comprenant la réalisation de nombreux échantillons complets, de l'élaboration de la poudre céramique jusqu'à la mise en forme finalisée, en variant certains des paramètres susmentionnés pour chaque échantillon afin de déterminer le procédé optimal. De plus, lorsqu'on veut modifier une couleur, même légèrement, il faut recommencer toute l'élaboration intégralement, incluant de nouveau la préparation de nombreux échantillons. La recherche d'une couleur maîtrisée d'un composant en céramique, souvent nécessaire pour son utilisation comme élément de décoration, exige donc des étapes complexes et fastidieuses de mise au point en pratique.

Enfin, malgré les nombreux essais, on constate à ce jour qu'il apparaît impossible d'obtenir des composants en céramique présentant certaines couleurs, notamment certaines couleurs grises comme celles définies par les coordonnées colorimétriques CIE L*a*b* (83 ; 0 ; 0.6) et CIE L*a*b* (47 ; 0.2 ; -0.2). De manière générale, une couleur par exemple définie par des paramètres a* et b* proches de zéro et un paramètre L* inférieur à 96, notamment une couleur strictement grise, est impossible à obtenir.

Ainsi, le but général de la présente invention est de proposer une solution de fabrication d'un composant en céramique, notamment pour une pièce d'horlogerie, qui ne comprend pas les inconvénients de l'état de la technique.

Plus précisément, un premier objet de la présente invention est de proposer une solution de fabrication d'une poudre céramique et d'un composant en céramique qui permet d'obtenir une céramique aux propriétés améliorées, notamment dont la coloration est maîtrisée et/ou notamment dotée de propriétés nouvelles ou optimisées par exemple parmi des propriétés mécaniques, thermiques, électriques, tribologiques.

Un second objet de la présente invention est de proposer une solution de fabrication simplifiée d'un composant en céramique coloré.

Un troisième objet de la présente invention est de proposer une céramique grise.

Un quatrième objet de la présente invention est de proposer une méthode simple de modification d'une poudre céramique potentiellement déjà colorée pour modifier la couleur résultante du composant céramique terminé.

### Brève description de l'invention

A cet effet, l'invention repose sur un procédé de fabrication d'une poudre céramique liantée ou d'un composant en céramique, notamment à base de zircone et/ou d'alumine et/ou d'aluminate de strontium, notamment pour pièce d'horlogerie ou de joaillerie, caractérisé en ce qu'il comprend une étape de dépôt d'au moins un élément ou composé additionnel sur une poudre céramique liantée par un dépôt physique en phase vapeur (PVD) et/ou par un dépôt chimique en phase vapeur (CVD) et/ou par un dépôt par couche atomique (ALD).

L'invention est plus précisément définie par les revendications.

### Brève description des figures

Ces objets, caractéristiques et avantages de la présente invention seront exposés en détail dans la description suivante d'un mode de réalisation particulier fait à titre non-limitatif en relation avec les figures jointes parmi lesquelles :
La figure 1 représente schématiquement un logigramme des étapes du procédé de fabrication d'un composant en céramique coloré pour pièce d'horlogerie selon un mode de réalisation de la présente invention.
La figure 2 représente un composant en céramique obtenu selon un premier exemple selon un mode de réalisation de l'invention.
La figure 3 représente un composant en céramique obtenu selon un deuxième exemple selon un mode de réalisation de l'invention.
La figure 4 représente un composant en céramique obtenu selon un troisième exemple selon un mode de réalisation de l'invention.
La figure 5 représente un composant en céramique obtenu selon un quatrième exemple selon un mode de réalisation de l'invention.
La figure 6 consiste en un tableau de résultats de composants en céramique obtenus selon sept exemples de mise en oeuvre d'un mode de réalisation de l'invention.
La figure 7 représente l'évolution de la clarté en fonction de la teneur en platine pour les composants en céramique des exemples 4 à 7 obtenus par un mode de réalisation de l'invention.
La figure 8 représente l'évolution du paramètre de chromaticité a* en fonction de la teneur en platine pour les composants en céramique des exemples 4 à 7 obtenus par un mode de réalisation de l'invention.
La figure 9 représente l'évolution du paramètre de chromaticité b* en fonction de la teneur en platine pour les composants en céramique des exemples 4 à 7 obtenus par un mode de réalisation de l'invention.
La figure 10 consiste en un tableau de résultats de composants en céramique obtenus selon des exemples de mise en oeuvre d'un mode de réalisation de l'invention.
La figure 11 consiste en un tableau de résultats de composants en céramique obtenus selon trois exemples de mise en oeuvre d'un mode de réalisation de l'invention.
La figure 12 consiste en un tableau de résultats d'un composant en céramique obtenu selon un exemple de mise en oeuvre d'un mode de réalisation de l'invention.
La figure 13 représente un composant en céramique obtenu selon un premier exemple selon un mode de réalisation de l'invention.
La figure 14 représente un composant en céramique obtenu selon un deuxième exemple selon un mode de réalisation de l'invention.
La figure 15 consiste en un tableau de résultats de composants en céramique obtenus selon les deux exemples précédents de mise en oeuvre d'un mode de réalisation de l'invention.

Par la suite, nous désignerons par composant ou poudre céramique un composant ou une poudre obtenu dans un matériau dense polycristallin comprenant principalement au moins une céramique, notamment à base de zircone et/ou d'alumine et/ou d'aluminate de strontium, par exemple une zircone stabilisée à l'oxyde d'yttrium et/ou de cérium et /ou de magnésium et/ou de calcium. On désignera par poudre céramique une poudre sous forme de solide finement divisé, composée de fines particules de céramique, notamment à base de zircone et/ou d'alumine et/ou d'aluminate de strontium. Pour simplifier la description, nous conserverons volontairement de manière élargie le même terme de poudre céramique pour une poudre comprenant principalement des fines particules de céramique, mais aussi d'autres éléments ajoutés comme par exemple un ou plusieurs pigments ou des oxydes visant à renforcer la céramique, tels que l'oxyde d'yttrium. De manière similaire, nous désignerons par composant céramique un composant par exemple obtenu par frittage d'une telle poudre céramique. Ainsi, la poudre ou composant céramique comprend dans tous les cas majoritairement une composante de type céramique, soit au moins 50% en poids de cette composante de type céramique, voire au moins 75%, voire au moins 90%. Par exemple, la poudre ou composant céramique comprend au moins 50% en poids de zircone.

Dans tous les cas, une poudre céramique ne contient pas de composé organique. Nous désignerons par le terme générique de poudre céramique liantée un matériau composite constitué par une poudre céramique et un liant, généralement constitué par un ou plusieurs composés organiques, dans des proportions variables, destiné à la mise en forme d'une pièce par pressage, par injection, par coulage ou par d'autres techniques.

Nous désignerons par granule (de pressage) un agglomérat de poudre céramique liantée, destiné à une mise en forme par un procédé de pressage, par exemple un pressage uniaxial à froid ou à chaud ou un pressage isostatique à froid ou à chaud. Un granule comprend en général entre 1% et 4% inclus en poids de composés organiques.

Nous désignerons par le terme de poudre céramique injectable, aussi généralement dénommée par le terme anglo-saxon de « feedstock », une poudre céramique liantée destinée à une mise en forme par un procédé d'injection, haute ou basse pression. Une poudre céramique injectable comprend en général entre 12 et 25% inclus en poids de composés organiques.

Nous désignerons par le terme de « slurry » une poudre céramique liantée destinée à une mise en forme par coulage en barbotine ou par gel-casting. Un slurry comprend en général entre 1% et 25% inclus en poids de composés organiques.

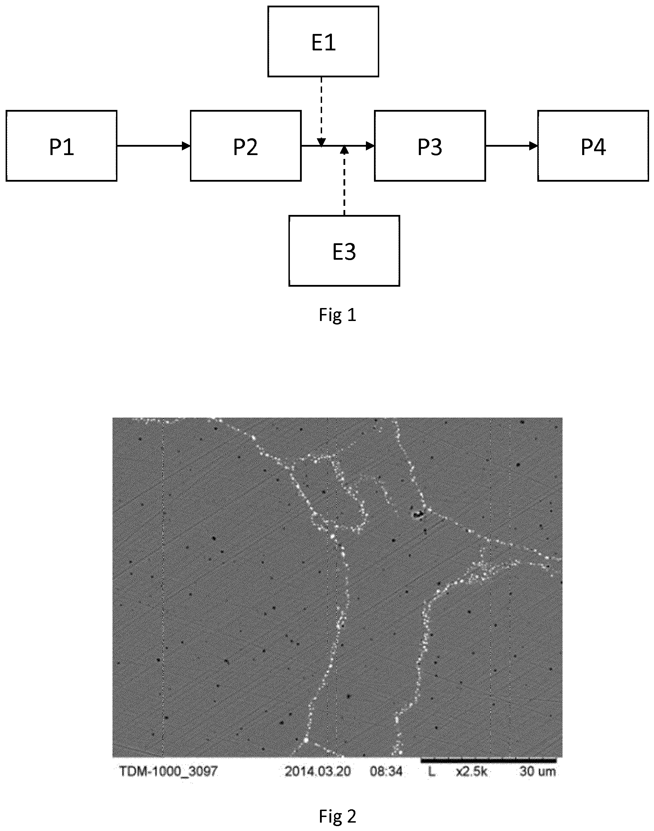

Le procédé de fabrication d'un composant céramique selon un mode de réalisation de l'invention comprend les phases et les étapes schématiquement représentées par le logigramme de la figure 1.

Ce procédé de fabrication comprend donc les phases habituelles P1 à P4 du procédé, à savoir la préparation de la poudre céramique (P1), l'ajout d'un liant (P2), la mise en forme du composant (P3) et le traitement thermique de déliantage-frittage (P4). Les parties traditionnelles de ces phases ne seront pas détaillées à ce stade puisqu'elles sont connues de l'état de la technique. L'homme du métier saura donc les mettre en oeuvre, y compris selon toutes les variantes ou équivalences existantes.

Le mode de réalisation de l'invention se distingue particulièrement du procédé traditionnel par l'ajout d'une étape de dépôt E3 sur une poudre céramique liantée d'au moins un élément ou composé additionnel, par exemple un élément de coloration, par voie sèche sous vide.

Selon une première variante de réalisation, l'étape de dépôt E3 consiste en un dépôt physique en phase vapeur, connu par le sigle PVD pour l'expression anglo-saxonne de « Physical Vapor Déposition », et/ou en un dépôt chimique en phase vapeur, connu par le sigle CVD pour l'expression anglo-saxonne de « Chimical Vapor Deposition ».

Selon une deuxième variante de réalisation, l'étape de dépôt E3 consiste en un dépôt par couche atomique, connu par le sigle ALD pour l'expression anglo-saxonne de «Atomic Layer Déposition ».

Cette étape de dépôt E3 est mise en oeuvre sur une poudre céramique liantée, donc après la deuxième phase P2 du procédé de fabrication. Elle est donc mise en oeuvre sur une poudre céramique comprenant des composés organiques, par exemple sur un granule ou sur du feedstock d'injection. Elle est mise en oeuvre avant la troisième phase P3 du procédé. Pour simplifier la description, nous continuerons d'appeler poudre céramique liantée la poudre céramique liantée comprenant un ou plusieurs élément(s) ou composé(s) additionnel(s), obtenue par la mise en oeuvre de l'étape de dépôt E3 de l'invention.

L'élément ou composé additionnel peut être très varié, particulièrement un métal, et/ou un oxyde, et/ou un nitrure ou et/ou un carbure. Nous entendons par métal, un métal pur ou un alliage. Il peut donc être avantageusement un composé à base métallique. A des fins de simplification, nous utiliserons dans la suite du document les termes d'élément additionnel ou de composé additionnel sans distinction, tant pour un élément seul que pour un composé ou un alliage.

De manière nouvelle, l'invention permet aussi l'utilisation de métaux qui ne pouvaient pas être utilisés avec les solutions existantes, comme les métaux nobles à haut point de fusion, supérieur ou égal à 1200° C, voire supérieur ou égal à 1500° C. Ainsi, l'invention permet d'utiliser comme élément additionnel le platine, et/ou le rhodium, et/ou l'osmium, et/ou le palladium, et/ou le ruthénium, et/ou l'iridium. En variante, d'autres métaux peuvent être utilisés, et on peut compléter la liste précédente par l'or, l'aluminium, l'argent, le rhénium, le titane, le tantale ou le niobium. En complément, les métaux de transition caractérisés par une couche d incomplète, selon la liste ci-après, permettent d'obtenir un résultat particulièrement inédit et intéressant du fait de leur ajout selon l'étape de dépôt E3 particulière de l'invention : le fer, le chrome, le vanadium, le manganèse, le cobalt, le nickel et le cuivre. De même, les lanthanides (La, Ce, Pr, Nd, Pm, Sm, Eu, Gd, Tb, Dy, Ho, Er, Tm, Yb et Lu) permettent de doper les poudres céramiques liantées lors de l'étape E3 et d'obtenir des couleurs et/ou des propriétés intéressantes. Comme mentionné ci-dessus, le composé additionnel peut donc être un alliage comprenant ou constitué d'un ou de plusieurs des métaux et lanthanides listés ci-dessus.

Ainsi, un composé additionnel peut être un composé ou alliage métallique, obtenu par le dépôt direct de l'alliage métallique sur la poudre céramique liantée ou par la combinaison de dépôts successifs ou simultanés de plusieurs des éléments de l'alliage métallique sur la poudre céramique liantée.

De manière similaire, un composé additionnel peut être un oxyde, un carbure ou un nitrure d'un ou de plusieurs métaux, obtenu par le dépôt direct de l'oxyde, du carbure, du nitrure sur la poudre céramique liantée ou par la réaction d'un dépôt métallique avec une atmosphère réactive, notamment dans l'enceinte de dépôt ou ultérieurement au dépôt, par exemple lors d'une étape de frittage du composé en céramique.

Naturellement, plusieurs éléments ou composés additionnels différents peuvent être utilisés et déposés sur la même poudre céramique liantée, simultanément ou successivement, par une ou plusieurs étapes de dépôt E3 telles que décrites ci-dessus. Cette augmentation des composés additionnels disponibles permet naturellement d'augmenter les couleurs possibles pour une céramique, ainsi que les autres propriétés possibles, notamment mécaniques ou tribologiques.

En remarque, l'homme du métier a l'habitude d'ajouter des pigments de couleur par voie liquide dans une céramique. Il n'est pas habitué à agir par voie sèche, ni à faire un dépôt directement sur une poudre céramique liantée. Lors d'un tel dépôt par voie sèche, les paramètres suivants sont à considérer :
- L'homogénéité du dépôt sur les poudres,
- L'homogénéité de forme et de taille des grains,
- Les températures du procédé,
- Le risque de dégazage,
- Le caractère électrostatique des solides divisés en mouvement (isolants),
- L'état de finition et la nature des matériaux de l'équipement ; il faut notamment bien choisir le couple entre la nature du dépôt et la nature des liants des granules pour éviter le collage de la poudre sur l'équipement.

Par exemple, lors d'un dépôt PVD, la déposition est avantageusement effectuée sur la poudre céramique liantée, par exemple sur des granules de pressage (taille moyenne de l'ordre de quelques dizaines de microns) ou sur des poudres céramiques injectables sous forme de pellets (taille moyenne de l'ordre de quelques millimètres) qui sont de plus grandes dimensions. Cette approche met ainsi en présence un substrat mixte comprenant une poudre céramique et des composés organiques dont la tenue en température est faible, une température maximale étant de 45 °C.

On s'aperçoit de plus que le procédé de l'invention permet d'atteindre des résultats très satisfaisants, au niveau des propriétés nouvelles ou améliorées des composants en céramique, même avec des quantités très faibles de composé additionnel ajouté à la céramique. Ainsi, la couleur d'un composant en céramique est non seulement améliorée par rapport aux solutions existantes en ce qu'elle est homogène et/ou peut permettre des teintes nouvelles, mais en plus, ce résultat amélioré est obtenu par l'ajout d'un élément ou composé additionnel de coloration en très faible quantité, notamment en quantité nettement inférieure à la quantité de pigments de coloration utilisée avec la méthode traditionnelle.

Par exemple, le procédé de dépôt PVD est utilisé avec une teneur en poids d'élément(s) ou de composé(s) additionnel(s) inférieure ou égale à 5%, voire inférieure ou égale à 3%, voire inférieure ou égale à 2%. Avantageusement, cette teneur est supérieure ou égale à 0,01%. Avantageusement, cette teneur est comprise entre 0.01% et 5% inclus, voire entre 0.01% et 3% inclus. En remarque, toutes les teneurs en poids sont mesurées sur le composant en céramique terminé (après réalisation de la quatrième phase du procédé de fabrication) ou sur la poudre céramique déliantée, c'est-à-dire en dehors de la considération du poids du liant. Le procédé de dépôt ALD est même utilisé pour obtenir des teneurs en poids encore inférieures, éventuellement inférieures ou égales à 5%, mais aussi notamment inférieures ou égales à 3% ou 2%, voire inférieures ou égales à 1%, voire inférieures ou égales à 0,05%, voire inférieures ou égales à 0,01%. Avantageusement, ces teneurs sont supérieures ou égales à 1 ppm.

Avantageusement, ces teneurs sont comprises entre 1 ppm et 0,01 % inclus, voire entre 1 ppm et 0,05% inclus, voire entre 1 ppm et 5% inclus. L'invention présente donc l'avantage d'obtenir des résultats très intéressants avec une faible quantité de matière de composé additionnel, voire une très faible quantité de matière, sans recourir à l'élaboration d'un lot complet à chaque fois, et en permettant de surcroît de modifier un lot de base par itérations.

Il est de plus important de souligner que le procédé de l'invention permet d'obtenir une répartition homogène ou une bonne dispersion d'un composé additionnel, et donc finalement d'obtenir un composant en céramique de propriété (par exemple couleur) homogène. En remarque, comme le composé additionnel est déposé après la deuxième phase P2 du procédé, donc par exemple directement sur des granules, le composé additionnel se trouve réparti en surface des granules du fait du procédé de dépôt utilisé, et est ainsi réparti de manière homogène sur la poudre céramique liantée. La conformité du dépôt permet de répartir le revêtement sur la poudre, et dans le cas d'un revêtement métallique, la poudre devient moins électrostatique. Elle s'agglomère moins. Le composé additionnel se retrouvera notamment réparti de manière homogène dans le composant en céramique fritté terminé.

De plus, le fait de procéder à l'enrobage d'une poudre liantée, et non d'une poudre céramique non liantée, présente l'avantage de travailler sur des matières facilement disponibles commercialement, et sur des particules de plus grande taille dont la récupération dans les équipements de dépose est plus aisée.

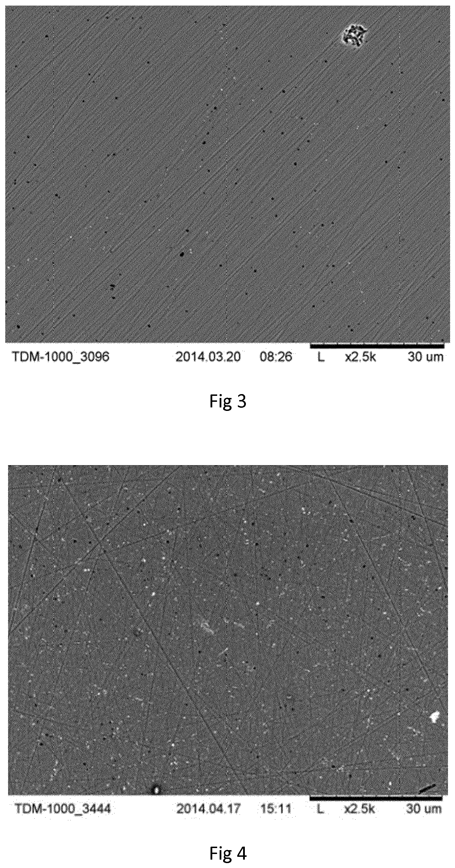

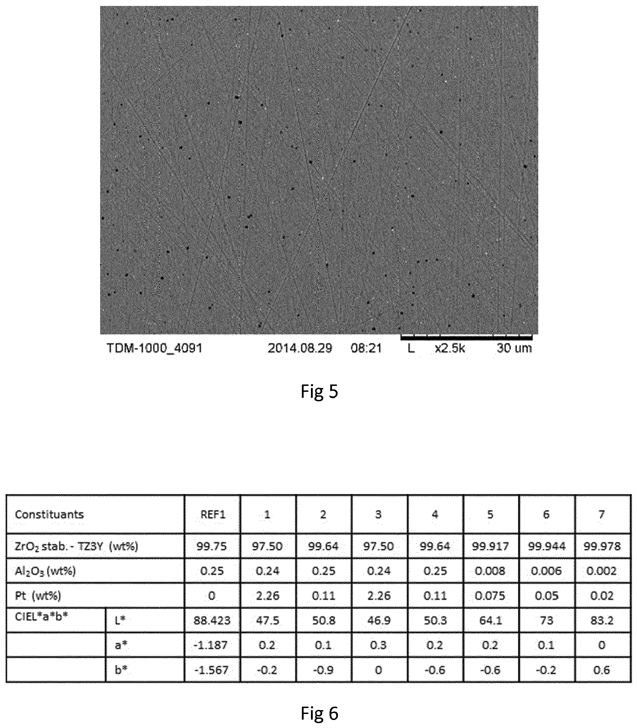

Dans tous les cas précédents, l'analyse du corps obtenu en fin de la quatrième phase montre que la répartition homogène du composé additionnel est conservée dans le composant en céramique finalisé. Si le dépôt PVD a été réalisé directement sur des granules de pressage, on retrouve dans la microstructure du composant en céramique une répartition ordonnée des particules de composé additionnel suivant une superstructure rappelant la microstructure des granules pressés (voir figures 2 et 3 commentées plus loin). En variante, cette répartition de petites particules de composé additionnel peut être parfaitement homogène en ajoutant après le dépôt une étape d'attrition (voir les figures 4 et 5). Dans le cas de dépôts sur le feedstock d'injection, l'homogénéisation de la répartition des particules du composé additionnel dans le matériau a notamment lieu lors de l'étape de plastification du mélange fondu par la vis d'injection. Ainsi, dans tous les cas, le composant en céramique comprend un élément additionnel réparti de manière homogène dans son volume, ce qui lui permet de présenter la propriété induite par cet élément additionnel réparti de manière homogène dans le composant en céramique.

Finalement, l'étape de dépôt E3 du mode de réalisation de l'invention apporte les avantages principaux suivants :
- Elle permet d'obtenir un ajout d'un élément ou composé additionnel parfaitement maîtrisé en termes de composition et de quantité et en très faible quantité, et permet donc de mettre en oeuvre un microdosage du composé additionnel ;
- Elle permet d'obtenir in fine une répartition homogène du composé additionnel dans le composant céramique ;
- Elle permet l'ajout d'une multitude de composés additionnels, augmentant le nombre de composés additionnels possibles par rapport aux solutions existantes, augmentant les possibilités pour doter un composant en céramique de certaines propriétés ;
- Elle permet un dépôt fiable, répétable et propre d'un composé additionnel.

L'invention est illustrée ci-dessous par des exemples qui permettent de fabriquer un composant en céramique grise, selon des teintes impossibles à fabriquer avec les techniques traditionnelles. Dans tous ces exemples, le composé additionnel est le platine, qui est déposé par dépôt PVD sur une poudre de pressage. Tous les résultats obtenus, notamment en termes de couleur, sont résumés dans le tableau de la figure 6.

Le premier exemple repose sur l'utilisation d'une poudre céramique liantée sous forme de granules, contenant de la zircone yttriée à 3 %molaire (TZ3Y) et comprenant 0.25 % en poids d'alumine et 3 % en poids de liants organiques (REF1). 50 grammes de ces granules sont placés dans le bol vibrant d'une enceinte PVD contenant une cathode en platine. L'enceinte PVD est mise sous vide puis le platine est pulvérisé avec un plasma d'argon. Une analyse par ICP (Inducted Coupled Plasma) a permis de doser la teneur en platine de ces granules, préalablement déliantés. Les échantillons issus de cet exemple contiennent globalement une teneur en platine de 2.26 % en poids. Les granules revêtus obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. A l'issue du frittage, les faces de la pastille en céramique sont rectifiées puis polies. Le composant en céramique obtenu est de couleur grise. La figure 2 est une image obtenue par microscopie électronique à balayage de la pastille en céramique obtenue, qui montre la répartition des particules de platine (points clairs). Cette figure permet de mettre en évidence la répartition ordonnée des particules de platine, en une superstructure microscopique, autour des anciens granules de pressage. A l'échelle du composant, la répartition des particules est homogène.

Le deuxième exemple est réalisé à partir d'une poudre de pressage liantée contenant de la zircone yttriée à 3 %molaire (TZ3Y) et comprenant 0.25 % en poids d'alumine et 3 % en poids de liants organiques, sous forme de granules (REF1). 50 grammes de ces granules sont placés dans le bol vibrant d'une enceinte PVD contenant une cathode en platine. L'enceinte PVD est mise sous vide puis le platine est pulvérisé avec un plasma d'argon. Une analyse par ICP (Inducted Coupled Plasma) a permis de doser la teneur en platine de ces granules préalablement déliantés. Les échantillons de cet exemple contiennent globalement une teneur en platine de 0.11 % en poids. Les granules revêtus obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. A l'issue du frittage, les faces de la pastille sont rectifiées puis polies. Le composant en céramique obtenu est de couleur grise. La figure 3 est une image obtenue par microscopie électronique à balayage de la pastille en céramique obtenue, qui montre la répartition de particules de platine (points clairs) au niveau des joints de grains. A l'échelle du composant, cette répartition est homogène. Du fait de la teneur très faible du platine, ces particules de platine sont peu visibles.

Dans le troisième exemple, une partie de la poudre obtenue lors de la réalisation de l'exemple 1 est prélevée. On ajoute alors une étape de déliantage puis un traitement d'attrition (mélange, broyage en voie liquide) et de liantage. Dans ce traitement, 0.47 g de PVA, 0.71 g de PEG 20 000, et 170 ml d'eau DI (déionisée) sont ajoutés à 39.4 g de poudre de l'exemple 1 déliantée. La suspension ainsi obtenue est placée dans le bol en zircone d'un attriteur avec 1 kg de billes de zircone pour être attritée durant 1 heure à 400 tour/minute. La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. Les échantillons de cet exemple contiennent toujours globalement la même teneur de 2.26 % en poids de platine que dans l'exemple 1. A l'issue du frittage, les faces de la pastille sont rectifiées puis polies. Le composant en céramique obtenu est de couleur grise. La figure 4 est une image obtenue par microscopie électronique à balayage de la pastille en céramique obtenue, qui montre la répartition microscopiquement homogène de particules de platine (points clairs) au sein des grains de zircone. Les différences de couleur des céramiques polies issues des exemples 1 et 3 sont imperceptibles à l'œil (Δ E<1) et dans l'erreur de mesure donnée par l'appareil ; nous estimerons donc que pour l'œil humain la répartition des particules de platine dans ces deux échantillons est équivalente en termes de couleur résultante.

Dans le quatrième exemple, une partie de la poudre obtenue lors de la réalisation du deuxième exemple est prélevée. On ajoute alors une étape de déliantage puis un traitement d'attrition et de liantage. Dans ce traitement, 0.46 g de PVA, 0.69 g de PEG 20 000, et 166 ml d'eau DI (déionisée) sont ajoutés à 38.5 g de poudre de l'exemple 2 déliantée. La suspension ainsi obtenue est placée dans le bol en zircone d'un attriteur avec 1 kg de billes de zircone pour être attritée durant 1 heure à 400 tour/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. Les échantillons de cet exemple contiennent toujours globalement la même teneur de 0.11 % en poids de platine que dans l'exemple 2. A l'issue du frittage, les faces de la pastille sont rectifiées puis polies. Le composant en céramique obtenu est de couleur grise. La figure 5 est une image obtenue par microscopie électronique à balayage de la pastille en céramique obtenue, qui montre la répartition microscopiquement homogène de particules de platine (points clairs) au sein des grains de zircone. Du fait de la teneur très faible du platine, ces particules de platine sont peu visibles à cette échelle. Les différences de couleur des céramiques polies issues des exemples 2 et 4 sont imperceptibles à l'œil (Δ E<1) et dans l'erreur de mesure donnée par l'appareil ; nous estimerons donc que pour l'œil humain la répartition des particules de platine dans ces deux échantillons est équivalente en termes de couleur résultante.

Dans le cinquième exemple, 3.32 g de la poudre obtenue lors de la réalisation du troisième exemple est prélevée et déliantée afin d'être mélangée avec 96.68 g de poudre commerciale (zircone yttriée 3 % molaire, non liantée) avant de subir un traitement d'attrition. Puis 1.2 g de PVA, 1.8 g de PEG 20 000, et 200 ml d'eau DI (déionisée) sont ajoutés à 100 g de poudre obtenue. La suspension ainsi obtenue est placée dans le bol en zircone d'un attriteur avec 1 kg de billes de zircone pour être attritée durant 70 minutes à 400 tours/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. Les échantillons de cet exemple contiennent une teneur de 0.075 % en poids de platine. A l'issue du frittage, les faces de la pastille sont rectifiées puis polies. Le composant en céramique obtenu est de couleur grise.

Dans le sixième exemple, 2.21 g de la poudre obtenue lors de la réalisation du troisième exemple est prélevée et déliantée afin d'être mélangée avec 97.79 g de poudre commerciale (zircone yttriée 3 % molaire, non liantée) avant de subir un traitement d'attrition. Puis 1.2 g de PVA, 1.8 g de PEG 20 000, et 200 ml d'eau DI (déionisée) sont ajoutés à 100 g de poudre obtenue. La suspension ainsi obtenue est placée dans le bol en zircone d'un attriteur avec 1 kg de billes de zircone pour être attritée durant 70 minutes à 400 tours/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. Les échantillons de cet exemple contiennent une teneur de 0.05 % en poids de platine. A l'issue du frittage, les faces de la pastille sont rectifiées puis polies. Le composant en céramique obtenu est de couleur grise.

Dans le septième exemple, 0.77 g de la poudre obtenue lors de la réalisation du troisième exemple est prélevée et déliantée afin d'être mélangée avec 99.23 g de poudre commerciale (zircone yttriée 3 % molaire, non liantée) avant de subir un traitement d'attrition. Puis 1.2 g de PVA, 1.8 g de PEG 20 000, et 200 ml d'eau DI (déionisée) sont ajoutés à 100 g de poudre obtenue. La suspension ainsi obtenue est placée dans le bol en zircone d'un attriteur avec 1 kg de billes de zircone pour être attritée durant 70 minutes à 400 tours/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. Les échantillons de cet exemple contiennent une teneur de 0.02 % en poids de platine. A l'issue du frittage, les faces de la pastille sont rectifiées puis polies. Le composant en céramique obtenu est de couleur grise.

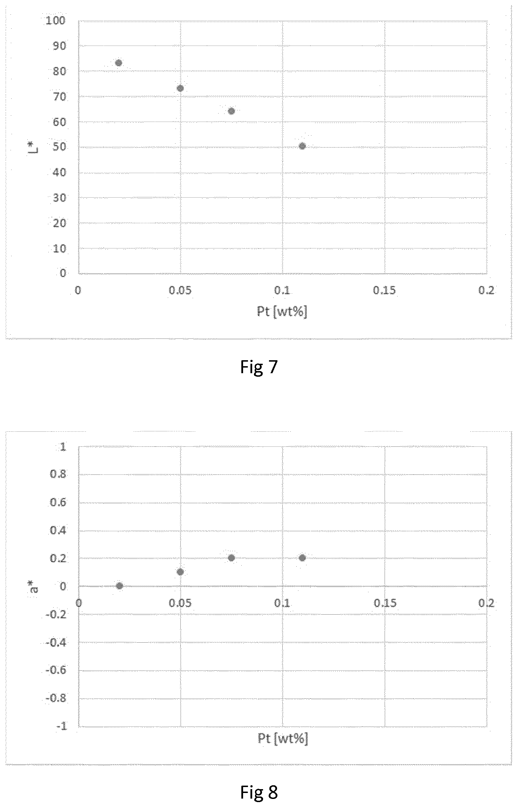

Le tableau de la figure 6 représente les résultats des sept exemples précédents. Il est intéressant de constater que tous ces exemples permettent d'obtenir une céramique grise. Ainsi, de manière générale, un mode de réalisation de l'invention permet avantageusement de fabriquer une céramique grise, caractérisée par les deux paramètres a* et b* compris entre -1 et 1 inclus. D'autre part, il est intéressant de noter que la teinte varie en fonction de la teneur en platine, comme cela est résumé par les figures 7 à 9.

En variante, un mode de réalisation de l'invention peut permettre de fabriquer un composant en céramique grise, caractérisée par les deux paramètres a* et b* compris entre -3 et 3 inclus, voire entre -2 et 2 inclus, voire entre -0,5 et 0,5 inclus.

En remarque, l'attrition après l'ajout du platine permet de mieux répartir le platine dans la matière (voir figures 2 à 5) et ne modifie pas significativement la couleur de la céramique obtenue dans ces exemples. On constate également une très légère augmentation de la densité des échantillons liée à l'attrition. Cette attrition reste toutefois optionnelle.

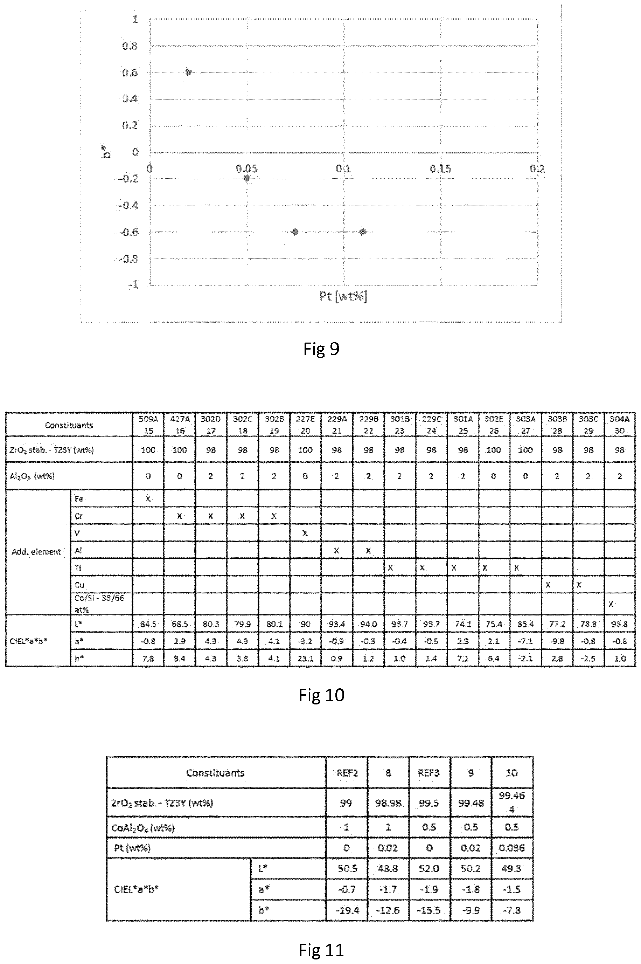

Naturellement, l'invention ne se limite pas à la fabrication d'un composant en céramique contenant du platine comme composé additionnel. Il est possible d'obtenir une couleur grise avec un autre composé additionnel que le platine par exemple avec du rhodium, du palladium ou tout autre métal noble gris ne réagissant pas avec les autres composants de la céramique ou l'atmosphère de frittage. De plus, l'invention ne se limite pas à la fabrication d'un composant en céramique gris. Il est en effet possible d'obtenir de nombreuses couleurs en variant le composé additionnel. Ainsi, le tableau de la figure 10 donne plusieurs exemples de composants en céramique obtenus par un procédé selon un mode de réalisation de l'invention avec différents composés additionnels. Plus précisément, des essais de dépôt de divers composés additionnels par dépôts PVD ont été réalisés directement sur des feedstocks d'injection céramique à base de zircone yttriée à 3 % molaire, avec ou sans adjonction d'alumine. On constate que l'ajout de fer Fe donne une céramique très légèrement jaune. L'ajout de chrome Cr sur une zircone stabilisée pure donne également une céramique jaune avec une légère tendance rouge. Le chrome déposé sur une zircone additionnée d'alumine de teneur 2 % en poids donne une matière plus claire, mais plus rouge. L'ajout de vanadium V rend la céramique jaune et l'ajout d'aluminium Al est quasi sans effet sur la couleur de base.

De manière optionnelle, le procédé de fabrication peut comprendre une étape préalable E1 d'ajout d'un autre composé à la poudre de céramique non liantée, par exemple l'ajout de pigments de coloration ou tout autre composé selon l'approche traditionnelle rappelée précédemment ou selon d'autres techniques connues de l'homme du métier, par exemple par précipitation de sels. En effet, l'invention reste compatible avec tous les autres procédés existants, et peut venir en complément, par exemple pour l'enrichir. Cette étape E1 peut être réalisée à tout moment opportun du procédé de fabrication.

En variante et de manière optionnelle, le procédé de fabrication peut comprendre une étape préalable E1 d'ajout d'un autre élément ou composé additionnel à la poudre de céramique liantée, notamment par un dépôt par couche atomique ALD. Particulièrement, une étape de dépôt ALD peut permettre de rendre la surface d'une poudre céramique conductrice, par exemple en ajoutant un composé additionnel métallique. Ceci offre l'avantage de limiter les risques d'agglomération de la poudre céramique liantée, notamment ultérieurement au sein d'une enceinte PVD, puisque les particules de cette poudre céramique liantée ont un caractère électrostatique qui tend à les rapprocher et à former naturellement des agglomérats, ce qui est désavantageux pour leur enrobage homogène avec un composé additionnel. En remarque, ce premier élément conducteur n'a pas besoin de recouvrir la surface totale des grains de poudre pour être efficace. On constate que le dépôt d'un composé additionnel par un dépôt PVD sur la poudre liantée, au cours de l'étape de dépôt E3, est facilité par la première fine couche formée par le dépôt ALD, formant une sous-couche conductrice limitant l'agglomération des particules. En remarque, le composé déposé par le dépôt ALD peut être identique à celui qui sera déposé par le dépôt PVD. En variante, les deux composés déposés par ALD et par PVD diffèrent, pour combiner leurs propriétés.

En variante, le dépôt d'un élément ou composé additionnel par ALD par l'étape préalable E1 peut être effectué sur une poudre céramique non liantée, donc avant la réalisation de la deuxième phase P2 du procédé. La poudre céramique ainsi enrichie peut subir une succession d'étapes de dispersion/broyage en voie liquide lors de la deuxième phase P2, pour la lianter avec un composé organique, avant de l'atomiser pour en faire par exemple des granules en fin de deuxième phase P2 du procédé. Cette deuxième phase P2 permet ainsi de répartir de manière homogène ledit élément ou composé additionnel.

Comme cela a été mentionné précédemment, la solution de l'état de la technique pour colorer un composant en céramique est complexe et n'est pas toujours satisfaisante. D'autre part, lorsqu'on souhaite modifier une teinte, même légèrement, d'un composant en céramique préalablement coloré à l'aide de pigments selon l'état de la technique, il apparaît très difficile de le faire avec la technique traditionnelle, notamment parce que les pigments ont tendance à réagir entre eux lors du frittage. Ainsi, selon l'état de la technique, il est long et fastidieux de modifier l'intensité (clarté) et/ou la teinte de la coloration d'une céramique colorée : en effet, chaque tentative nécessite la réalisation d'un nouveau lot de poudre céramique ayant une nouvelle composition chimique, puis la fabrication d'un feedstock d'injection, et jusqu'à la réalisation des composants céramiques terminés (frittés et polis).

Avec le procédé de l'invention, il devient beaucoup plus facile de réaliser une telle modification de couleur ou d'intensité. Plus généralement, toute autre modification de propriété du composant en céramique devient facilement réalisable.

Ainsi, un mode de réalisation de l'invention repose sur un procédé de fabrication d'une poudre céramique ou d'un composant en céramique, notamment à base de zircone et/ou d'alumine et/ou d'aluminate de strontium, qui comprend les étapes suivantes :
- Se munir d'une poudre céramique liantée contenant des pigments de coloration ou plus généralement d'au moins un composé ajouté ou additionnel qui permettraient d'obtenir un composant en céramique d'une première couleur ou plus généralement doté d'une première propriété par fabrication d'un composant en céramique à partir de cette poudre céramique liantée ;
- Déposer E3 au moins un élément ou composé additionnel, de coloration ou autre, sur ladite poudre céramique liantée par un dépôt physique en phase vapeur PVD et/ou par un dépôt chimique en phase vapeur CVD et/ou par un dépôt par couche atomique ALD ;
- Finaliser la fabrication du composant en céramique à partir de la poudre céramique liantée incluant le composé additionnel déposé afin d'obtenir un composant en céramique dont la couleur est une deuxième couleur, différente de la première couleur, ou plus généralement doté d'une deuxième propriété, différente de la première propriété.

Par un tel procédé, une première propriété obtenue à partir d'une poudre céramique liantée du commerce peut être facilement modifiée en une deuxième propriété par l'ajout d'un composé additionnel selon un mode de réalisation de l'invention. Comme ce mode de réalisation de l'invention met en oeuvre une étape E3 facile à implémenter, à maîtriser et à reproduire, il devient aisé de procéder à plusieurs essais pour obtenir par tâtonnement la propriété finale souhaitée pour le composant en céramique, sans exiger une intervention fastidieuse au niveau de l'élaboration d'une poudre céramique.

Ainsi, le procédé de fabrication d'un composant en céramique peut répéter des étapes de dépôt d'au moins un composé additionnel sur ladite poudre céramique liantée, en modifiant la teneur dudit composé additionnel, voire le composé additionnel lui-même, et de finalisation de la fabrication du composant en céramique, jusqu'à s'approcher suffisamment du résultat souhaité.

En pratique, il est donc possible de mettre en oeuvre une étape de sélection d'une poudre céramique liantée contenant des pigments de coloration permettant d'obtenir une première couleur s'approchant d'une deuxième couleur souhaitée, puis de modifier la couleur par l'ajout d'un composé additionnel de coloration, jusqu'à s'approcher suffisamment de la couleur souhaitée. La même approche peut être mise en oeuvre pour modifier toute autre propriété que la couleur, comme mentionné précédemment.

Avantageusement, le au moins un composé additionnel est choisi non réactif avec les composés ajoutés déjà présents dans la poudre céramique liantée, par exemple des pigments de coloration.

Les pigments présents dans la poudre céramique liantée peuvent comprendre un ou plusieurs éléments parmi un oxyde métallique, un oxyde de terre rare, un aluminate de cobalt, et/ou des pigments phosphorescents.

Les trois exemples suivants, numérotés exemples huit à dix, illustrent ce principe, dans le cas d'un composant en céramique contenant un aluminate de cobalt (pigment bleu). Les résultats sont présentés dans le tableau de la figure 11.

Dans le huitième exemple, un composant en céramique est initialement coloré à partir d'une poudre céramique commerciale de zircone yttriée à 3 % molaire (TZ3Y) contenant 0.25 % en poids d'alumine, et à laquelle a été ajoutée une quantité de 3 % en poids de liants organiques ainsi que 1 % en poids de pigment CoAl₂O₄ par la voie humide conventionnelle (REF2). La suspension obtenue est séchée et granulée par atomisation. Les granules sont ensuite pressés pour obtenir un échantillon. Cet échantillon est délianté et fritté, pour obtenir un composant en céramique, de couleur bleue caractérisée par les paramètres suivants CIE L*a*b* (50.5 ; -0.7 ; -19.4).

Selon le mode de réalisation de l'invention, la poudre céramique liantée décrite ci-dessus (REF2) est d'abord déliantée ; on en prélève 99 g. La poudre obtenue lors du premier exemple est également déliantée ; on en prélève 1 g. Les deux prélèvements sont regroupés. Puis, 1.2 g de PVA, 1.8 g de PEG 20 000, et 200 ml d'eau DI sont ajoutés à 100 g de cette poudre céramique modifiée. La suspension ainsi obtenue est placée dans le bol en zircone d'un attriteur avec 1 kg de billes de zircone, pour être attritée durant 70 minutes à 400 tours/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600°C durant 18 heures. Elle est finalement frittée sous air à 1450°C avec un palier de 2 heures, selon un cycle connu de l'homme du métier. Les échantillons de ce huitième exemple contiennent 0.02 % en poids de platine. A l'issue du frittage, les faces de la pastille sont rectifiées puis polies. La couleur modifiée est ensuite constatée (voir figure 11).

Le neuvième exemple considère d'abord la fabrication d'une poudre de zircone yttriée 3% molaire (TZ3Y) contenant 3 % en poids de liants organiques, ainsi que 0.5 % en poids de pigments CoAl₂O₄ intégrés par la voie humide conventionnelle (REF3). La suspension obtenue est séchée et granulée par atomisation. Les granules sont ensuite pressés pour obtenir un échantillon. Cet échantillon est délianté et fritté. La céramique obtenue est de couleur bleue, de paramètres CIE L*a*b* (52.0 ; -1.9 ; -15.5).

Ensuite, des granules (REF3) utilisés pour fabriquer ce composant en céramique à base de zircone sont déliantés. 1 g de la poudre déliantée du premier exemple est ajouté à 99 g de cette poudre céramique déliantée. Dès lors, on ajoute à ces 100 g de poudre mélangée 1.2 g de PVA, 1.8 g de PEG 20 000, et 200 ml d'eau DI. La suspension obtenue est placée dans le bol en zircone d'un attriteur avec 1 kg de billes de zircone pour être attritée durant 70 minutes à 400 tours/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de 2 heures. Les échantillons de ce neuvième exemple contiennent 0.02 % en poids de platine. A l'issue du frittage, les faces de la pastille sont rectifiées puis polies. Le composant en céramique présente ainsi une couleur modifiée (voir paramètres présentés en figure 11).

Dans le dixième exemple, un composant en céramique est formé à partir d'une poudre commerciale de zircone yttriée à 3% molaire (TZ3Y) contenant 0.25 % en poids d'alumine, contenant 3 % en poids de liants organiques et 0.5 % en poids de pigment CoAl₂O₄, ajoutés par la voie humide conventionnelle (REF3). La suspension obtenue est séchée et granulée par atomisation. Les granules sont ensuite pressés pour obtenir un échantillon. Cet échantillon est délianté et fritté. La céramique obtenue est de couleur bleue, de paramètres CIE L*a*b* (52.0 ; -1.9 ; -15.5).

Selon le mode de réalisation, des granules (REF3) utilisés pour fabriquer le composant en céramique précédent sont d'abord déliantés. Ensuite, 1.8 g de la poudre céramique déliantée de l'exemple 1 est ajouté à 98.2 g de cette poudre céramique déliantée. Puis, 1.2 g de PVA, 1.8 g de PEG 20 000, et 200 ml d'eau DI sont ajoutés à 100 g de la poudre céramique modifiée. La suspension ainsi obtenue est placée dans le bol en zircone d'un attriteur avec 1 kg de billes de zircone pour être attritée durant 70 minutes à 400 tour/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée sous air à 1450°C avec un palier de 2 heures. Les échantillons de ce dixième exemple contiennent donc 0.036 % en poids de platine. A l'issue du frittage, les faces de la pastille sont rectifiées puis polies. Le composant en céramique présente ainsi une couleur modifiée (voir paramètres présentés en figure 11).

Les trois exemples précédents sont basés sur l'utilisation du mode de réalisation de l'invention pour atteindre facilement une couleur souhaitée, à partir d'une poudre céramique pigmentée dont la couleur est finalement modifiée.

De manière plus générale, le mode de réalisation de l'invention est simplement compatible avec toutes les autres techniques d'ajout d'au moins un composé à une poudre céramique liantée. Ainsi, l'invention peut être combinée à toute autre technique, notamment à une approche traditionnelle, pour obtenir toute sorte de céramique aux propriétés nouvelles.

A titre d'exemple, un onzième exemple considère une poudre céramique de zircone yttriée à 3 % molaire, à laquelle a été ajoutée une quantité de 30 % en poids de pigment luminescent Sr₄Al₁₄O₂₅:Dy,Eu ainsi que 3 % en poids de liants organiques par la voie humide conventionnelle (REF4). La suspension obtenue est séchée et granulée par atomisation. Les granules sont pressés, déliantés sous air et frittés à 1450 °C durant 2 heures sous une atmosphère particulière. Ce procédé traditionnel permet d'obtenir une céramique de couleur définie par des paramètres CIE L*a*b* (94.0 ; -4.7 ; 6.7).

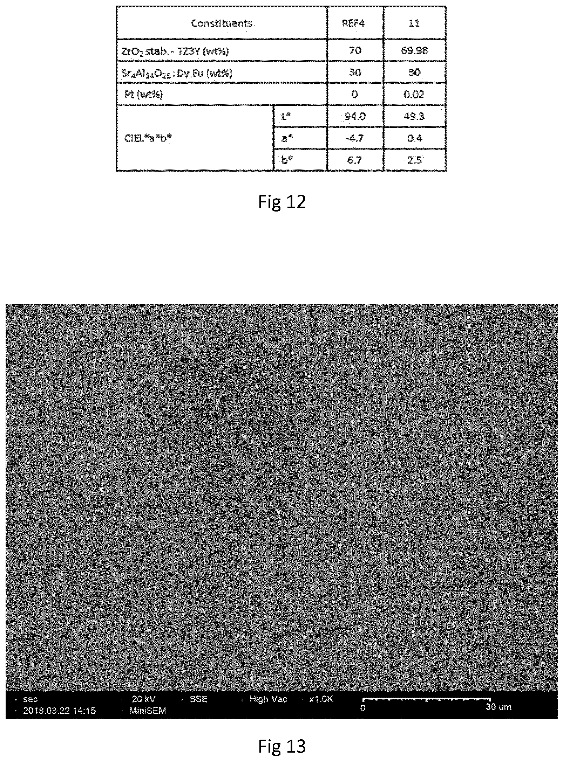

En variante de réalisation de l'invention, les granules de la poudre céramique composite utilisée ci-dessus (REF4) sont déliantés. Puis 1 g de la poudre déliantée du premier exemple sont ajoutés à 99 g de cette poudre. Dès lors, 1.2 g de PVA, 1.8 g de PEG 20 000, et 200 ml d'eau DI sont ajoutés à 100 g de la poudre obtenue. La suspension ainsi résultante est placée dans le bol en zircone d'un attriteur avec 1 kg de billes de zircone pour être attritée durant 70 minutes à 400 tour/minute. La suspension est ensuite recueillie pour être séchée et granulée par atomisation à l'aide d'un « Spray Dryer ». Les granules obtenus sont ensuite pressés dans un moule cylindrique sur une presse uniaxiale. La pastille ainsi obtenue est déliantée sous air à 600 °C durant 18 heures. Elle est finalement frittée à 1450 °C avec un palier de 2 heures sous une atmosphère particulière. Les échantillons de ce onzième exemple contiennent 0.02 % en poids de platine. A l'issue du frittage, les faces de la pastille sont rectifiées puis polies. Il en résulte ainsi un composant en céramique coloré et luminescent, par une combinaison de l'invention avec un procédé traditionnel, dont les caractéristiques précises sont résumées dans le tableau de la figure 12. En variante, d'autres couleurs pourraient être conférées à un tel composant en céramique phosphorescent ou luminescent par l'ajout d'autres éléments ou composés additionnels.

Les exemples précédents reposent sur l'utilisation d'un composé additionnel pour obtenir un composant en céramique coloré, parce que de tels exemples présentent l'avantage d'illustrer l'invention de manière très significative car visuelle.

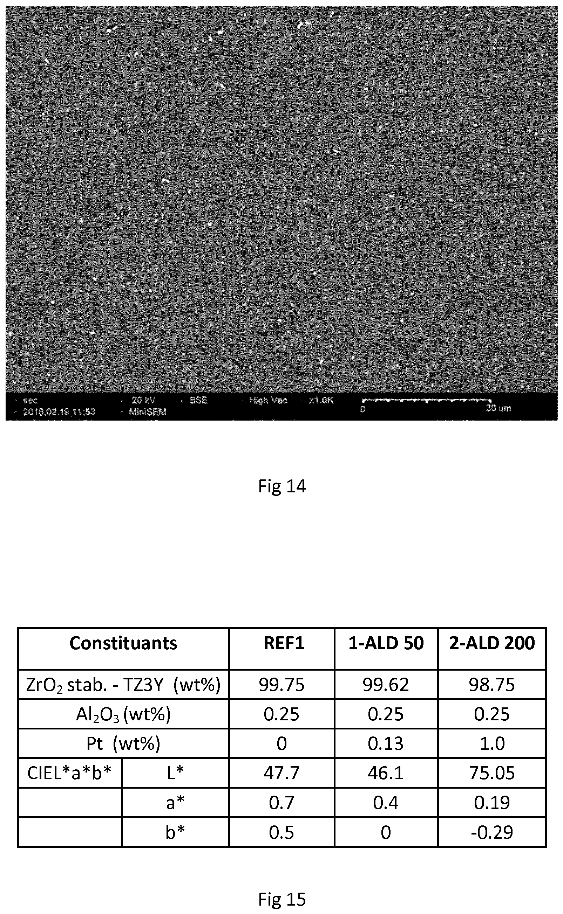

Des exemples ci-dessous permettent de fabriquer un composant en céramique grise, selon des teintes impossibles à fabriquer avec les techniques traditionnelles, à partir de l'utilisation spécifique du procédé ALD, sur une poudre non liantée. Tous les résultats obtenus, notamment en termes de couleur, sont résumés dans le tableau de la figure 15.

Le premier exemple repose sur l'utilisation d'une poudre céramique, non liantée, composée de zircone yttriée à 3 %molaire (TZ3YS). 10 grammes de cette poudre sont placés dans le bol vibrant d'une enceinte ALD, qui est mise sous vide, afin d'engager le dépôt de platine par le procédé ALD. 50 cycles de dépôt sont réalisés.

La poudre céramique ainsi revêtue subit ensuite un traitement d'attrition (mélange, broyage en voie liquide) et de liantage. Dans ce traitement, 0.6 g de PVA, 0.9 g de PEG 20 000, et 116 ml d'eau déionisée sont ajoutés à 50.4 g de ladite poudre céramique, recouverte de platine. La suspension ainsi obtenue est placée dans le bol en zircone d'un attriteur avec 1 kg de billes de zircone, pour être attritée/broyée durant 2 heures à 400 tour/minute. La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. A l'issue du frittage, les faces de la pastille en céramique sont rectifiées puis polies. Le composant en céramique obtenu est de couleur grise. La figure 13 est une image obtenue au microscope électronique à balayage (MEB) de la pastille en céramique frittée, qui montre la répartition des particules de platine (points clairs). Cette figure permet de mettre en évidence la répartition homogène des particules de platine. En effet, à l'échelle du composant, nous considérons la répartition de ces particules comme homogène. La couleur résultante apparaît homogène à l'œil nu. La couleur et la composition sont données dans le tableau de la figure 15 sous la référence 1 ALD 50.

Le deuxième exemple repose sur l'utilisation d'une poudre céramique, non liantée, composée de zircone yttriée à 3 % molaire (TZ3YS). 10 grammes de cette poudre sont placés dans le bol vibrant d'une enceinte ALD, qui est mise sous vide, afin d'engager le dépôt de platine par le procédé ALD. 200 cycles de dépôt sont réalisés. La poudre céramique ainsi revêtue subit ensuite un traitement d'attrition (mélange, broyage en voie liquide) et de liantage. Dans ce traitement, 0.6 g de PVA, 0.9 g de PEG 20 000, et 120 ml d'eau déionisée sont ajoutés à 50.4 g de ladite poudre céramique, recouverte de platine. La suspension ainsi obtenue est placée dans le bol en zircone d'un attriteur avec 1 kg de billes de zircone, pour être attritée/broyée durant 2 heures à 400 tour/minute.

La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air à 600 °C durant 18 heures. Elle est finalement frittée sous air à 1450 °C avec un palier de deux heures. A l'issue du frittage, les faces de la pastille en céramique sont rectifiées puis polies. Le composant en céramique obtenu est de couleur grise. La figure 14 est une image obtenue au microscope électronique à balayage (MEB) de la pastille en céramique frittée, qui montre la répartition des particules de platine (points clairs). Cette figure permet de mettre en évidence la répartition homogène des particules de platine. En effet, à l'échelle du composant, nous considérons la répartition de ces particules comme homogène. La couleur résultante apparaît homogène à l'œil nu. La couleur et la composition sont données dans le tableau de la figure 15 sous la référence 2 ALD 200..

Le tableau de la figure 15 représente les résultats des deux exemples précédents. Il est intéressant de constater que ces exemples permettent d'obtenir une céramique grise. Ainsi, de manière générale, un mode de réalisation de l'invention permet avantageusement de fabriquer une céramique grise, caractérisée par les deux paramètres a* et b* compris entre -1 et 1 inclus.

En variante, un mode de réalisation de l'invention peut permettre de fabriquer un composant en céramique grise, caractérisée par les deux paramètres a* et b* compris entre -3 et 3 inclus, voire entre -2 et 2 inclus, voire entre -0,5 et 0,5 inclus.

De plus, la coloration d'un composant en céramique est particulièrement importante pour une pièce d'horlogerie ou de joaillerie, parce qu'elle permet d'obtenir une esthétique souhaitée. Ainsi, l'invention est particulièrement intéressante pour fabriquer un composant horloger ou de joaillerie. Ce composant horloger peut notamment être une lunette de montre, un cadran, un index, une couronne de remontoir, un poussoir ou tout autre élément d'habillage horloger ou d'un mouvement horloger. L'invention porte aussi sur une pièce d'horlogerie, notamment une montre, comprenant un tel composant horloger.

Naturellement, l'invention ne se limite pas à une couleur particulière, ni à une propriété donnée d'un composant en céramique. En effet, le concept de l'invention est de multiplier et simplifier l'enrichissement possible d'un composant en céramique, et l'invention rend finalement possible la fabrication d'une multitude de nouveaux composants en céramique.

Notamment, un composant en céramique obtenu par un mode de réalisation de l'invention comprend au moins une propriété particulière obtenue par une quantité très faible d'un composé additionnel réparti dans le composant en céramique. Cette quantité très faible est inférieure ou égale à 5% en poids, ou inférieure ou égale à 3% en poids, ou inférieure ou égale à 1% en poids, ou inférieure ou égale à 0,05% en poids, ou inférieure ou égale à 0,01% en poids, rapporté à la masse totale du composé en céramique finalisé. Cette quantité sera de plus avantageusement supérieure ou égale à 1 ppm, ou supérieure ou égale à 10 ppm.

Il est également décrit un dispositif de fabrication d'un composant en céramique caractérisé en ce qu'il met en oeuvre le procédé de fabrication d'un composant en céramique. Pour cela, le dispositif de fabrication comprend une chambre pour effectuer dépôt physique en phase vapeur (PVD) ou un dépôt chimique en phase vapeur (CVD) ou un dépôt par couche atomique (ALD).

## Revendications

1. Procédé de fabrication d'une poudre céramique liantée comprenant au moins un élément ou composé additionnel, ladite poudre céramique liantée étant notamment à base de zircone et/ou d'alumine et/ou d'aluminate de strontium, **caractérisé en ce qu'**il comprend une étape de dépôt (E3) d'au moins un élément ou composé additionnel sur une poudre céramique liantée, constituée d'une poudre céramique et d'un liant destiné à la mise en forme d'une pièce et constitué par un ou plusieurs composés organiques, par un dépôt physique en phase vapeur (PVD) et/ou par un dépôt chimique en phase vapeur (CVD) et/ou par un dépôt par couche atomique (ALD).

2. Procédé de fabrication d'une poudre céramique liantée selon la revendication précédente, **caractérisé en ce que** l'étape de dépôt (E3) comprend l'ajout du au moins un élément ou composé additionnel en quantité totale dans la poudre céramique, en dehors du ou des composé(s) organique(s), inférieure ou égale à 5% en poids, ou inférieure ou égale à 3% en poids, ou inférieure ou égale à 1 % en poids, ou inférieure ou égale à 0,05% en poids, ou inférieure ou égale à 0,01% en poids.

3. Procédé de fabrication d'une poudre céramique liantée selon l'une des revendications précédentes, **caractérisé en ce que** l'étape de dépôt (E3) comprend l'ajout du au moins un élément ou composé additionnel en quantité totale supérieure ou égale à 1 ppm, ou supérieure ou égale à 10 ppm, en dehors du ou des composé(s) organique(s).

4. Procédé de fabrication d'une poudre céramique liantée selon la revendication 1, **caractérisé en ce que** l'étape de dépôt (E3) comprend le dépôt d'au moins un élément ou composé additionnel sur une poudre céramique liantée par un dépôt physique en phase vapeur (PVD) et/ou par un dépôt chimique en phase vapeur (CVD), en quantité comprise entre 0,01 et 5% inclus en poids, ou entre 0,01% et 3% inclus en poids ou entre 0.01% et 1% inclus en poids, en dehors du ou des composé(s) organique(s).

5. Procédé de fabrication d'une poudre céramique liantée selon la revendication 1, **caractérisé en ce que** l'étape de dépôt (E3) comprend le dépôt d'au moins un élément ou composé additionnel sur une poudre céramique liantée par un dépôt par couche atomique (ALD) en quantité comprise entre 1 ppm et 5% inclus en poids, voire 1 ppm et 3% inclus en poids, voire entre 1 ppm et 0,05% inclus en poids, ou entre 1 ppm et 0,01% inclus en poids, en dehors du ou des composé(s) organique(s).

6. Procédé de fabrication d'une poudre céramique liantée selon l'une des revendications précédentes, **caractérisé en ce que** l'étape de dépôt (E3) comprend le dépôt d'un élément ou composé additionnel choisi parmi un métal, et/ou un alliage métallique, et/ou un oxyde, et/ou un nitrure et/ou un carbure.

7. Procédé de fabrication d'une poudre céramique liantée selon la revendication précédente, **caractérisé en ce que** l'élément ou le composé additionnel est ou comprend un métal choisi parmi l'une des quatre listes suivantes :
- un métal noble à haut point de fusion, choisi parmi le platine, le rhodium, l'osmium, le palladium, le ruthénium, ou l'iridium, ou
- tout autre métal choisi parmi l'or, l'aluminium, l'argent, le rhénium, le titane, le tantale ou le niobium, ou
- un métal de transition choisi parmi l'aluminium, le fer, le chrome, le vanadium, le manganèse, le cobalt, le nickel ou le cuivre.
- un lanthanide choisi parmi le lanthane, le cérium, le praséodyme, le néodyme, le prométhium, le samarium, l'europium, le gadolinium, le terbium, le dysprosium, l'holmium, l'erbium, le thulium, l'ytterbium ou le lutécium.

8. Procédé de fabrication d'une poudre céramique liantée selon l'une des revendications précédentes, **caractérisé en ce que** le composé additionnel est un alliage métallique, obtenu par le dépôt direct de l'alliage métallique sur la poudre céramique liantée ou par la combinaison de dépôts successifs ou simultanés de plusieurs des éléments de l'alliage métallique sur la poudre céramique liantée.

9. Procédé de fabrication d'une poudre céramique liantée selon l'une des revendications 1 à 7, **caractérisé en ce que** le composé additionnel est un oxyde, un carbure ou un nitrure d'un ou de plusieurs métaux, obtenu par le dépôt direct de l'oxyde, du carbure, du nitrure sur la poudre céramique liantée ou par la réaction d'un dépôt métallique avec une atmosphère réactive, notamment dans l'enceinte de dépôt ou ultérieurement au dépôt, par exemple lors d'une étape de frittage du composé en céramique.

10. Procédé de fabrication d'une poudre céramique liantée selon l'une des revendications précédentes, **caractérisé en ce que** l'étape de dépôt (E3) comprend le dépôt simultané ou successif de plusieurs éléments ou composés additionnels différents.

11. Procédé de fabrication d'une poudre céramique liantée selon l'une des revendications précédentes, **caractérisé en ce que** l'étape de dépôt (E3) comprend l'ajout d'au moins un élément ou composé additionnel sur une poudre céramique liantée, comprenant un composé organique en quantité comprise entre 1 % à 4% inclus en poids ou comprise entre 12% à 25% inclus en poids.

12. Procédé de fabrication d'une poudre céramique liantée selon l'une des revendications précédentes, **caractérisé en ce qu'**il comprend :
- une première phase (P1) consistant à préparer une poudre céramique, notamment à base de zircone et/ou d'alumine et/ou d'aluminate de strontium, puis
- optionnellement, une étape de dépôt (E1) comprenant le dépôt d'au moins un élément ou composé additionnel sur ladite poudre céramique par un dépôt par couche atomique (ALD), puis
- une deuxième phase (P2) consistant à intégrer un liant de type matière organique à la poudre céramique comprenant le au moins un élément ou composé additionnel ; puis,
- une étape de dépôt (E3) comprenant le dépôt d'au moins un élément ou composé additionnel sur ladite poudre en céramique liantée.

13. Procédé de fabrication d'un composant en céramique, **caractérisé en ce qu'**il comprend une phase de fabrication d'une poudre céramique liantée selon l'une des revendications précédentes.

14. Procédé de fabrication d'un composant en céramique selon la revendication précédente, **caractérisé en ce qu'**après l'étape de dépôt (E3) comprenant le dépôt d'au moins un élément ou composé additionnel, le procédé de fabrication met en oeuvre :
- une troisième phase (P3) de mise en forme provisoire de la poudre céramique liantée comprenant le au moins un élément ou composé additionnel, puis
- une quatrième phase (P4) comprenant une étape de déliantage du composant en céramique en forme provisoire consistant notamment en la suppression des composés organiques puis une étape de frittage du composant en céramique.

15. Procédé de fabrication d'un composant en céramique selon l'une des revendications 13 ou 14, **caractérisé en ce qu'**il comprend une étape consistant à ajouter des pigments de coloration, ou des pigments phosphorescents à la poudre céramique, liantée ou non, avant ou après une étape de dépôt (E3) d'au moins un élément ou composé additionnel, notamment un composé de coloration différent des pigments de coloration.

16. Procédé de fabrication d'un composant en céramique selon l'une des revendications 13 à 15, **caractérisé en ce qu'**il comprend les étapes suivantes
- Se munir d'une poudre céramique liantée contenant des pigments de coloration ou plus généralement au moins un composé ajouté et/ou additionnel qui permettraient d'obtenir un composant en céramique d'une première couleur ou plus généralement doté d'une première propriété par fabrication d'un composant en céramique à partir de cette poudre céramique liantée ;
- Déposer (E3) au moins un élément ou composé additionnel sur ladite poudre céramique liantée par un dépôt physique en phase vapeur (PVD) et/ou par un dépôt chimique en phase vapeur (CVD) et/ou par un dépôt par couche atomique (ALD) ;
- Finaliser la fabrication du composant en céramique à partir de la poudre céramique liantée incluant l'élément ou le composé additionnel déposé afin d'obtenir un composant en céramique dont la couleur est une deuxième couleur, différente de la première couleur, ou plus généralement doté d'une deuxième propriété, différente de la première propriété.

17. Procédé de fabrication d'un composant en céramique selon la revendication précédente, **caractérisé en ce qu'**il comprend la répétition d'étapes de dépôt d'au moins un élément ou composé additionnel sur ladite poudre céramique liantée, avec plusieurs dépôts différents d'au moins un composé additionnel, en variant la quantité et/ou le composé additionnel, jusqu'à s'approcher suffisamment d'une deuxième couleur ou d'une deuxième propriété souhaitée après finalisation de la fabrication du composant en céramique.

18. Procédé de fabrication d'un composant en céramique selon la revendication 16 ou 17, **caractérisé en ce qu'**il comprend une étape de sélection d'une poudre céramique liantée contenant au moins un composé permettant d'obtenir une première propriété s'approchant d'une deuxième propriété souhaitée.

19. Procédé de fabrication d'un composant en céramique selon l'une des revendications 13 à 18, **caractérisé en ce qu'**il permet de fabriquer une lunette de montre, un cadran, un index, une couronne de remontoir, un poussoir ou tout autre élément d'habillage horloger ou tout élément d'un mouvement horloger.

20. Poudre céramique liantée comprenant un liant constitué par un ou plusieurs composés organiques obtenue par un procédé selon l'une des revendications 1 à 12, **caractérisée en ce qu'**elle comprend un élément ou composé additionnel choisi parmi un métal, un alliage métallique, un oxyde, un nitrure ou un carbure, en quantité totale inférieure ou égale à 5% en poids, ou inférieure ou égale à 3% en poids, ou inférieure ou égale à 1% en poids, ou inférieure ou égale à 0,05% en poids, inférieure ou égale à 0,01 % en poids, cette quantité se mesurant en dehors des composés organiques.

## Patentansprüche

1. Verfahren zur Herstellung eines gebinderten Keramikpulvers, das mindestens ein zusätzliches Element oder eine zusätzliche Verbindung umfasst, wobei das gebinderte Keramikpulver insbesondere auf Basis von Zirkon und/oder Aluminiumoxid und/oder Strontiumaluminat ist, **dadurch gekennzeichnet, dass** es einen Schritt des Abscheidens (E3) mindestens eines zusätzlichen Elements oder mindestens einer zusätzlichen Verbindung auf ein gebindertes Keramikpulver, das aus einem Keramikpulver und aus einem Binder besteht, der zum Informbringen eines Teils bestimmt ist und aus einer oder mehreren organischen Verbindungen besteht, durch physikalische Gasphasenabscheidung (PVD) und/oder durch chemische Gasphasenabscheidung (CVD) und/oder durch Atomlagenabscheidung (ALD) umfasst.

2. Verfahren zur Herstellung eines gebinderten Keramikpulvers nach dem vorhergehenden Anspruch, **dadurch gekennzeichnet, dass** der Abscheideschritt (E3) das Zugeben des mindestens einen zusätzlichen Elements oder der mindestens einen zusätzlichen Verbindung in einer Gesamtmenge in dem Keramikpulver, abgesehen von der oder den organischen Verbindung(en), kleiner oder gleich 5 Gew.-% oder kleiner oder gleich 3 Gew.-% oder kleiner oder gleich 1 Gew.-% oder kleiner oder gleich 0,05 Gew.-% oder kleiner oder gleich 0,01 Gew.-% umfasst.

3. Verfahren zur Herstellung eines gebinderten Keramikpulvers nach einem der vorhergehenden Ansprüche, **dadurch gekennzeichnet, dass** der Abscheideschritt (E3) das Zugeben des mindestens einen zusätzlichen Elements oder der mindestens einen zusätzlichen Verbindung in einer Gesamtmenge größer als oder gleich 1 ppm oder größer als oder gleich 10 ppm, abgesehen von der oder den organischen Verbindung(en), umfasst.

4. Verfahren zur Herstellung eines gebinderten Keramikpulvers nach Anspruch 1, **dadurch gekennzeichnet, dass** der Abscheideschritt (E3) das Abscheiden mindestens eines zusätzlichen Elements oder mindestens einer zusätzlichen Verbindung auf ein gebindertes Keramikpulver durch eine physikalische Gasphasenabscheidung (PVD) und/oder durch eine chemische Gasphasenabscheidung (CVD) in einer Menge von 0,01 bis einschließlich 5 Gew.-% oder von 0,01 bis einschließlich 3 Gew.-% oder von 0,01 bis einschließlich 1 Gew.-%, abgesehen von der oder den organischen Verbindung(en), umfasst.

5. Verfahren zur Herstellung eines gebinderten Keramikpulvers nach Anspruch 1, **dadurch gekennzeichnet, dass** der Abscheideschritt (E3) das Abscheiden mindestens eines zusätzlichen Elements oder mindestens einer zusätzlichen Verbindung auf ein gebindertes Keramikpulver durch eine Atomlagenabscheidung (ALD) in einer Menge von 1 ppm bis einschließlich 5 Gew.-% oder sogar von 1 ppm bis einschließlich 3 Gew.-% oder sogar von 1 ppm bis einschließlich 0,05 Gew.-% oder von 1 ppm bis einschließlich 0,01 Gew.-%, abgesehen von der oder den organischen Verbindung(en), umfasst.

6. Verfahren zur Herstellung eines gebinderten Keramikpulvers nach einem der vorhergehenden Ansprüche, **dadurch gekennzeichnet, dass** der Abscheideschritt (E3) das Abscheiden eines zusätzlichen Elements oder einer zusätzlichen Verbindung umfasst, die unter einem Metall und/oder einer Metalllegierung und/oder einem Oxid und/oder einem Nitrid und/oder einem Carbid gewählt ist.

7. Verfahren zur Herstellung eines gebinderten Keramikpulvers nach dem vorhergehenden Anspruch, **dadurch gekennzeichnet, dass** das zusätzliche Element oder die zusätzliche Verbindung ein Metall ist oder umfasst, das aus einer der vier folgenden Listen gewählt ist:
- ein Edelmetall mit hohem Schmelzpunkt, das unter Platin, Rhodium, Osmium, Palladium, Ruthenium oder Iridium gewählt ist, oder
- ein anderes Metall, das unter Gold, Aluminium, Silber, Rhenium, Titan, Tantal oder Niob gewählt ist, oder
- ein Übergangsmetall, das unter Aluminium, Eisen, Chrom, Vanadium, Mangan, Cobalt, Nickel oder Kupfer gewählt ist,
- ein Lanthanoid, das unter Lanthan, Cer, Praseodym, Neodym, Promethium, Samarium, Europium, Gadolinium, Terbium, Dysprosium, Holmium, Erbium, Thulium, Ytterbium oder Lutetium gewählt ist.

8. Verfahren zur Herstellung eines gebinderten Keramikpulvers nach einem der vorhergehenden Ansprüche, **dadurch gekennzeichnet, dass** die zusätzliche Verbindung eine Metalllegierung ist und durch direktes Abscheiden der Metalllegierung auf das gebinderte Keramikpulver oder durch die Kombination von aufeinanderfolgenden oder gleichzeitigen Abscheidungen von mehreren der Elemente der Metalllegierung auf das gebinderte Keramikpulver erhalten wird.

9. Verfahren zur Herstellung eines gebinderten Keramikpulvers nach einem der Ansprüche 1 bis 7, **dadurch gekennzeichnet, dass** die zusätzliche Verbindung ein Oxid, ein Carbid oder ein Nitrid eines oder mehrerer Metalle ist und durch direktes Abscheiden des Oxids, des Carbids, des Nitrids auf das gebinderte Keramikpulver oder durch die Reaktion einer metallischen Abscheidung mit einer reaktionsfreudigen Atmosphäre, insbesondere in der Abscheidekammer oder nach dem Abscheiden, zum Beispiel bei einem Schritt des Sinterns der Verbindung zu Keramik, erhalten wird.

10. Verfahren zur Herstellung eines gebinderten Keramikpulvers nach einem der vorhergehenden Ansprüche, **dadurch gekennzeichnet, dass** der Abscheideschritt (E3) das gleichzeitige oder aufeinanderfolgende Abscheiden von mehreren unterschiedlichen zusätzlichen Elementen oder Verbindungen umfasst.

11. Verfahren zur Herstellung eines gebinderten Keramikpulvers nach einem der vorhergehenden Ansprüche, **dadurch gekennzeichnet, dass** der Abscheideschritt (E3) das Zugeben mindestens eines zusätzlichen Elements oder mindestens einer zusätzlichen Verbindung zu einem gebinderten Keramikpulver umfasst, umfassend eine organische Verbindung in einer Menge von 1 bis einschließlich 4 Gew.-% oder von 12 bis einschließlich 25 Gew.-%.

12. Verfahren zur Herstellung eines gebinderten Keramikpulvers nach einem der vorhergehenden Ansprüche, **dadurch gekennzeichnet, dass** es umfasst:
- eine erste Phase (P1), die darin besteht, ein Keramikpulver zuzubereiten, insbesondere auf Basis von Zirkon und/oder von Aluminiumoxid und/oder von Strontiumaluminat, dann
- optional, einen Abscheideschritt (E1), der das Abscheiden mindestens eines zusätzlichen Elements oder mindestens einer zusätzlichen Verbindung auf das Keramikpulver durch eine Atomlagenabscheidung (ALD) umfasst, dann
- eine zweite Phase (P2), die darin besteht, einen Binder vom Typ organische Materie in das organische Pulver einzuarbeiten, das das mindestens eine zusätzliche Element oder die mindestens eine zusätzliche Verbindung umfasst; dann,
- einen Abscheideschritt (E3), der das Abscheiden mindestens eines zusätzlichen Elements oder mindestens einer zusätzlichen Verbindung auf das gebinderte Keramikpulver umfasst.

13. Verfahren zur Herstellung eines Keramikbauteils, **dadurch gekennzeichnet, dass** es eine Phase der Herstellung eines gebinderten Keramikpulvers nach einem der vorhergehenden Ansprüche umfasst.

14. Verfahren zur Herstellung eines Keramikbauteils nach dem vorhergehenden Anspruch, **dadurch gekennzeichnet, dass** das Verfahren nach dem Abscheideschritt (E3), der das Abscheiden mindestens eines zusätzlichen Elements oder mindestens einer zusätzlichen Verbindung umfasst, durchführt:
- eine dritte Phase (P3) des vorläufigen Informbringens des gebinderten Keramikpulvers, das das mindestens eine zusätzliche Element oder die mindestens eine zusätzliche Verbindung umfasst, dann
- eine vierte Phase (P4), die einen Schritt des Entbinderns des Keramikbauteils in der vorläufigen Form umfasst, der insbesondere in dem Beseitigen der organischen Verbindungen besteht, dann einen Schritt des Sinterns des Keramikbauteils.

15. Verfahren zur Herstellung eines Keramikbauteils nach einem der Ansprüche 13 oder 14, **dadurch gekennzeichnet, dass** es einen Schritt umfasst, der darin besteht, farbgebende Pigmente oder phosphoreszierende Pigmente zu dem Keramikpulver, gebindert oder nicht, vor oder nach einem Schritt des Abscheidens (E3) mindestens eines zusätzlichen Elements oder mindestens einer zusätzlichen Verbindung, insbesondere einer farbgebenden Verbindung, die verschieden von den farbgebenden Pigmenten ist, zuzugeben.

16. Verfahren zur Herstellung eines Keramikbauteils nach einem der Ansprüche 13 bis 15, **dadurch gekennzeichnet, dass** es die folgenden Schritte umfasst:
- Beschaffen eines gebinderten Keramikpulvers, das farbgebende Pigmente oder allgemeiner mindestens eine zugegebene und/oder zusätzliche Verbindung enthält, die es ermöglichen würden, ein Keramikbauteil mit einer ersten Farbe oder allgemeiner mit einer ersten Eigenschaft durch Herstellen eines Keramikbauteils aus diesem gebinderten Keramikpulver zu erhalten;
- Abscheiden (E3) mindestens eines zusätzlichen Elements oder mindestens einer zusätzlichen Verbindung auf das gebinderte Keramikpulver durch eine physikalische Gasphasenabscheidung (PVD) und/oder durch eine chemische Gasphasenabscheidung (CVD) und/oder durch eine Atomlagenabscheidung (ALD);
- Abschließen der Herstellung des Keramikbauteils aus dem gebinderten Keramikpulver, das das abgeschiedene zusätzliche Element oder die abgeschiedene zusätzliche Verbindung beinhaltet, um ein Keramikbauteil zu erhalten, dessen Farbe eine zweite Farbe ist, die von der ersten Farbe verschieden ist, oder das allgemeiner mit einer zweiten Eigenschaft versehen ist, die von der ersten Eigenschaft verschieden ist.

17. Verfahren zur Herstellung eines Keramikbauteils nach dem vorhergehenden Anspruch, **dadurch gekennzeichnet, dass** es die Wiederholung von Schritten des Abscheidens mindestens eines zusätzlichen Elements oder mindestens einer zusätzlichen Verbindung auf das gebinderte Keramikpulver umfasst, mit mehreren verschiedenen Abscheidungen mindestens einer zusätzlichen Verbindung, wobei die Menge und/oder die zusätzliche Verbindung geändert wird, bis man einer erwünschten zweiten Farbe oder zweiten Eigenschaft nach Abschluss der Herstellung des Keramikbauteils ausreichend nahe kommt.

18. Verfahren zur Herstellung eines Keramikbauteils nach Anspruch 16 oder 17, **dadurch gekennzeichnet, dass** es einen Schritt des Auswählens eines gebinderten Keramikpulvers umfasst, das mindestens eine Verbindung enthält, die es ermöglicht, eine erste Eigenschaft zu erhalten, die einer erwünschten zweiten Eigenschaft nahe kommt.

19. Verfahren zur Herstellung eines Keramikbauteils nach einem der Ansprüche 13 bis 18, **dadurch gekennzeichnet, dass** es ermöglicht, eine Uhrenlünette, ein Zifferblatt, einen Zeiger, eine Aufzugskrone, einen Drücker oder jedes andere Uhrausstattungselement oder jedes Element eines Uhrwerks herzustellen.

20. Gebindertes Keramikpulver, das einen Binder umfasst, der aus einer oder mehreren organischen Verbindungen besteht, und das mit einem Verfahren nach einem der Ansprüche 1 bis 12 erhalten wird, **dadurch gekennzeichnet, dass** es ein zusätzliches Element oder eine zusätzliche Verbindung, das oder die unter einem Metall, einer Metalllegierung, einem Oxid, einem Nitrid oder einem Carbid gewählt ist, in einer Gesamtmenge kleiner als oder gleich 5 Gew.-% oder kleiner als oder gleich 3 Gew.-% oder kleiner als oder gleich 1 Gew.-% oder kleiner als oder gleich 0,05 Gew.-%, kleiner als oder gleich 0,01 Gew.-% umfasst, wobei diese Menge abgesehen von den organischen Verbindungen gemessen wird.

## Claims

1. A process for manufacturing a ceramic powder with binder comprising at least one additional element or compound, said ceramic powder with binder being in particular based on zirconia and/or alumina and/or strontium aluminate, **characterized in that** it comprises a step (E3) of depositing at least one additional element or compound on a ceramic powder with binder, made of a ceramic powder and a binder intended for the shaping of a part and consisting of one or more organic compounds, by a physical vapour deposition (PVD) and/or by a chemical vapour deposition (CVD) and/or by an atomic layer deposition (ALD).

2. The process for manufacturing a ceramic powder with binder as claimed in the preceding claim, **characterized in that** the deposition step (E3) comprises the addition of the at least one additional element or compound in a total amount in the ceramic powder, excluding the organic compound(s), of less than or equal to 5% by weight, or less than or equal to 3% by weight, or less than or equal to 1% by weight, or less than or equal to 0.05% by weight, or less than or equal to 0.01% by weight.

3. The process for manufacturing a ceramic powder with binder as claimed in either of the preceding claims, **characterized in that** the deposition step (E3) comprises the addition of the at least one additional element or compound in a total amount of greater than or equal to 1 ppm, or greater than or equal to 10 ppm, excluding the organic compound(s).

4. The process for manufacturing a ceramic powder with binder as claimed in claim 1, **characterized in that** the deposition step (E3) comprises the deposition of at least one additional element or compound on a ceramic powder with binder by a physical vapour deposition (PVD) and/or by a chemical vapour deposition (CVD), in an amount of between 0.01% and 5% inclusive by weight, or between 0.01% and 3% inclusive by weight or between 0.01% and 1% inclusive by weight, excluding the organic compound(s).

5. The process for manufacturing a ceramic powder with binder as claimed in claim 1, **characterized in that** the deposition step (E3) comprises the deposition of at least one additional element or compound on a ceramic powder with binder by an atomic layer deposition (ALD) in an amount of between 1 ppm and 5% inclusive by weight, or even 1 ppm and 3% inclusive by weight, or even between 1 ppm and 0.05% inclusive by weight, or between 1 ppm and 0.01% inclusive by weight, excluding the organic compound(s).

6. The process for manufacturing a ceramic powder with binder as claimed in one of the preceding claims, **characterized in that** the deposition step (E3) comprises the deposition of an additional element or compound chosen from a metal, and/or a metal alloy, and/or an oxide, and/or a nitride and/or a carbide.

7. The process for manufacturing a ceramic powder with binder as claimed in the preceding claim, **characterized in that** the additional element or compound is or comprises a metal chosen from one of the following four lists:
- a noble metal with a high melting point, chosen from platinum, rhodium, osmium, palladium, ruthenium, or iridium, or
- any other metal chosen from gold, aluminium, silver, rhenium, titanium, tantalum or niobium, or
- a transition metal chosen from aluminium, iron, chromium, vanadium, manganese, cobalt, nickel or copper,
- a lanthanide chosen from lanthanum, cerium, praseodymium, neodymium, promethium, samarium, europium, gadolinium, terbium, dysprosium, holmium, erbium, thulium, ytterbium or lutetium.

8. The process for manufacturing a ceramic powder with binder as claimed in one of the preceding claims, **characterized in that** the additional compound is a metal alloy, obtained by the direct deposition of the metal alloy on the ceramic powder with binder or by the combination of successive or simultaneous depositions of several of the elements of the metal alloy on the ceramic powder with binder.

9. The process for manufacturing a ceramic powder with binder as claimed in one of claims 1 to 7, **characterized in that** the additional compound is an oxide, a carbide or a nitride of one or more metals, obtained by the direct deposition of the oxide, carbide or nitride on the ceramic powder with binder or by the reaction of a metallic deposition with a reactive atmosphere, in particular in the deposition chamber or after the deposition, for example during a step of sintering the ceramic compound.

10. The process for manufacturing a ceramic powder with binder as claimed in one of the preceding claims, **characterized in that** the deposition step (E3) comprises the simultaneous or successive deposition of several different additional elements or compounds.

11. The process for manufacturing a ceramic powder with binder as claimed in one of the preceding claims, **characterized in that** the deposition step (E3) comprises the addition of at least one additional element or compound to a ceramic powder with binder, comprising an organic compound in an amount of between from 1% to 4% inclusive by weight or between from 12% to 25% inclusive by weight.

12. The process for manufacturing a ceramic powder with binder as claimed in one of the preceding claims, **characterized in that** it comprises:
- a first phase (P1) consisting in preparing a ceramic powder, in particular based on zirconia and/or alumina and/or strontium aluminate, then
- optionally, a deposition step (E1) comprising the deposition of at least one additional element or compound on said ceramic powder by an atomic layer deposition (ALD), then
- a second phase (P2) consisting in integrating a binder of organic material type into the ceramic powder comprising the at least one additional element or compound; then,
- a deposition step (E3) comprising the deposition of at least one additional element or compound on said ceramic powder with binder.

13. A process for manufacturing a ceramic component, **characterized in that** it comprises a phase of manufacturing a ceramic powder with binder as claimed in one of the preceding claims.

14. The process for manufacturing a ceramic component as claimed in the preceding claim, **characterized in that** after the deposition step (E3) comprising the deposition of at least one additional element or compound, the manufacturing process carries out:
- a third phase (P3) of provisional shaping of the ceramic powder with binder comprising the at least one additional element or compound, then
- a fourth phase (P4) comprising a step of debinding the provisionally shaped ceramic component consisting in particular of the elimination of the organic compounds then a step of sintering the ceramic component.

15. The process for manufacturing a ceramic component as claimed in either of claims 13 and 14, **characterized in that** it comprises a step consisting in adding colouring pigments, or phosphorescent pigments to the bound or ceramic powder without binder, before or after a step (E3) of depositing at least one additional element or compound, in particular a colouring compound other than the colouring pigments.

16. The process for manufacturing a ceramic component as claimed in one of claims 13 to 15, **characterized in that** it comprises the following steps:
- providing a ceramic powder with binder containing colouring pigments or more generally at least one added and/or additional compound that would make it possible to obtain a ceramic component of a first colour or more generally endowed with a first property, by manufacturing a ceramic component from this ceramic powder with binder;
- depositing (E3) at least one additional element or compound on said ceramic powder with binder by a physical vapour deposition (PVD) and/or by a chemical vapour deposition (CVD) and/or by an atomic layer deposition (ALD);
- completing the manufacture of the ceramic component from the ceramic powder with binder including the deposited additional element or compound in order to obtain a ceramic component, the colour of which is a second colour, different from the first colour, or more generally that is endowed with a second property, different from the first property.

17. The process for manufacturing a ceramic component as claimed in the preceding claim, **characterized in that** it comprises the repetition of steps of depositing at least one additional element or compound on said ceramic powder with binder, with several different depositions of at least one additional compound, by varying the amount and/or the additional compound, until it has come sufficiently close to a desired second colour or second property after completion of the manufacture of the ceramic component.

18. The process for manufacturing a ceramic component as claimed in claim 16 or 17, **characterized in that** it comprises a step of selecting a ceramic powder with binder containing at least one compound that makes it possible to obtain a first property that comes close to a desired second property.

19. The process for manufacturing a ceramic component as claimed in one of claims 13 to 18, **characterized in that** it makes it possible to manufacture a watch bezel, a dial, an index, a winding crown, a push button or any other horological casing element or any element of a horological movement.

20. A ceramic powder with binder comprising a binder consisting of one or more organic compounds obtained by a process as claimed in one of claims 1 to 12, **characterized in that** it comprises an additional element or compound chosen from a metal, a metal alloy, an oxide, a nitride or a carbide, in a total amount of less than or equal to 5% by weight, or less than or equal to 3% by weight, or less than or equal to 1% by weight, or less than or equal to 0.05% by weight, less than or equal to 0.01% by weight, this amount being measured without the organic compounds.
